# FASCICULE DE BREVET EUROPEEN

(11) **EP 3 657 556 B1**
(45) Date de publication et mention de la délivrance du brevet: **02.06.2021**
(21) Numéro de dépôt: 19210679.7
(22) Date de dépôt: 21.11.2019
(51) Int. Cl.: H01L 31/18, H01L 31/105, H01L 31/103, H01L 31/028, H01L 31/0312, H01L 31/0352, H01L 31/0216, H01L 31/0232

(54) **PROCEDE DE FABRICATION D'AU MOINS UNE PHOTODIODE PLANAIRE PASSIVEE A COURANT D'OBSCURITE REDUIT**
HERSTELLUNGSVERFAHREN MINDESTENS EINER PASSIVIERTEN PLANAREN FOTODIODE MIT REDUZIERTEM DUNKELSTROM
METHOD FOR MANUFACTURING AT LEAST ONE PASSIVATED PLANAR PHOTODIODE WITH REDUCED DARK CURRENT

(30) Priorité: 23.11.2018 FR 1871729
(43) Date de publication de la demande: 27.05.2020
(73) Titulaire: Commissariat à l'Énergie Atomique et aux Énergies Alternatives, 75015 Paris (FR)
(72) Inventeur: ALIANE, Abdelkader, 38054 Grenoble cedex 09 (FR); OUVRIER-BUFFET, Jean-Louis, 38054 Grenoble cedex 09 (FR); ANDRE, Luc, 38054 Grenoble cedex 09 (FR); KAYA, Hacile, 38054 Grenoble Cedex 09 (FR)
(74) Mandataire: INNOV-GROUP

(56) Documents cités:
- EP-A1- 3 151 290
- US-A1- 2005 101 073
- US-A1- 2010 301 442
- SOOD ASHOK K ET AL: "Characterization of SiGe-detector arrays for visible-NIR imaging sensor applications", INFRARED TECHNOLOGY AND APPLICATIONS XXXVII, SPIE, 1000 20TH ST. BELLINGHAM WA 98225-6705 USA, vol. 8012, no. 1, 13 mai 2011 (2011-05-13) , pages 1-10, XP060016938, DOI: 10.1117/12.889205

## Description

### DOMAINE TECHNIQUE

Le domaine de l'invention est celui des dispositifs optoélectroniques comportant une ou plusieurs photodiodes planaires passivées. L'invention trouve une application notamment dans le domaine de la détection d'un rayonnement lumineux appartenant par exemple au proche infrarouge, la ou les photodiodes pouvant alors être réalisées à base de germanium.

### ÉTAT DE LA TECHNIQUE ANTÉRIEURE

Les dispositifs optoélectroniques de photodétection peuvent comporter une matrice de photodiodes planaires passivées. Les photodiodes s'étendent alors suivant un même plan principal, entre des première et deuxième faces opposées et parallèles entre elles. Elles comportent alors chacune une première région dopée par exemple de type n et affleurant la première face, et une deuxième région dopée par exemple de type p et affleurant la deuxième face. Les deux régions dopées sont alors séparées l'une de l'autre par une région intermédiaire intrinsèque ou très peu dopée par exemple de type p. Une couche de passivation recouvre la première face dans le but de limiter la contribution du courant d'obscurité au courant électrique mesuré par chaque photodiode.

Cependant, il apparaît que la présence de la couche de passivation peut malgré tout contribuer à générer un courant d'obscurité non négligeable. Ainsi, l'article de Sood et al. intitulé Characterization of SiGe-Detector Arrays for Visible-NIR Imaging Sensor Applications, Proc. of SPIE VOL. 8012, 801240, 2011, décrit un procédé de fabrication d'une photodiode planaire passivée permettant de limiter le courant d'obscurité. Le courant d'obscurité est lié à la présence d'une zone déplétée située dans le matériau semiconducteur de la photodiode, à l'interface avec la couche de passivation. Le procédé de fabrication comporte alors une étape de recuit sous N₂H₂ de la photodiode, permettant de transformer cette zone déplétée en une zone d'accumulation de trous. Il apparaît que cette étape permet alors de réduire l'intensité du courant d'obscurité.

Cependant, cette étape de recuit, destinée à modifier la zone déplétée en une zone d'accumulation, peut induire une dégradation des performances de la photodiode, notamment du fait d'une modification non souhaitée des dimensions de la première région dopée n, en particulier lorsque la longueur de diffusion des éléments dopants de type n est importante. Par ailleurs, la présence et les caractéristiques de la zone déplétée peuvent être liées à la technique utilisée de dépôt de la couche de passivation ainsi qu'aux conditions opératoires. Il en résulte que le recuit en question peut alors ne pas permettre d'obtenir de manière reproductible la zone d'accumulation souhaitée et donc la réduction voulue du courant d'obscurité.

Les documents US 2010/301442 A1 et EP 3 151 290 A1 divulguent des photodiodes planaires.

### EXPOSÉ DE L'INVENTION

L'invention a pour objectif de remédier au moins en partie aux inconvénients de l'art antérieur, et plus particulièrement de proposer un procédé de fabrication d'une ou plusieurs photodiodes planaires passivées permettant d'obtenir un faible courant d'obscurité tout en préservant les propriétés de la ou des photodiodes, et en particulier les dimensions de la ou des premières régions dopées.

Pour cela, l'objet de l'invention est un procédé de fabrication d'au moins une photodiode planaire passivée, comportant les étapes suivantes :
i) réalisation d'une portion semiconductrice dite de détection, présentant une première et une deuxième faces opposées l'une à l'autre et parallèles à un plan principal de la photodiode, et comportant :
   o une région dite intermédiaire affleurant la première face,
   o une région dite inférieure dopée selon un deuxième type de conductivité et affleurant la deuxième face,
ii) dépôt d'une couche de passivation, réalisée en un matériau diélectrique, recouvrant la première face, et formation dans la couche de passivation d'au moins une ouverture traversante débouchant sur la première face et entourant au moins partiellement dans le plan principal une partie centrale de la portion semiconductrice de détection ;
iii) réalisation d'une portion latérale réalisée en un matériau semiconducteur dopé selon le deuxième type de conductivité et destinée à être polarisée électriquement, située au contact de la région inférieure. La portion latérale peut entourer la portion semiconductrice de détection dans le plan principal.

Selon l'invention, le procédé comporte les étapes suivantes :
iv) réalisation d'au moins une portion périphérique, réalisée en un matériau semiconducteur contenant des éléments dopants selon le deuxième type de conductivité, et venant au contact, ou reposant sur et au contact, de la première face au travers de l'ouverture traversante ;
v) recuit, assurant une diffusion des éléments dopants depuis la portion périphérique vers la portion semiconductrice de détection, formant ainsi dans la portion semiconductrice de détection une région périphérique dopée selon le deuxième type de conductivité, affleurant la première face et entourant la partie centrale dans le plan principal, la région périphérique étant destinée à être située entre, et à une distance non nulle, d'une région dite supérieure et de la portion latérale ;
vi) réalisation, dans la partie centrale de la portion semiconductrice de détection, de la région supérieure dopée selon un premier type de conductivité opposé au deuxième type et destinée à être polarisée électriquement, affleurant la première face et séparée de la région inférieure par la région intermédiaire, et entourée dans le plan principal par la région périphérique.

Certains aspects préférés mais non limitatifs de ce procédé de fabrication sont les suivants.

Le procédé peut comportant une étape de réalisation, préalablement à l'étape de recuit, d'une portion latérale réalisée en un matériau semiconducteur dopé selon le deuxième type de conductivité, au contact et entourant la portion semiconductrice de détection dans le plan principal, l'étape de recuit assurant en outre une diffusion d'éléments dopants selon le deuxième type de conductivité depuis la portion latérale vers la portion semiconductrice de détection, formant ainsi dans la portion semiconductrice de détection une région latérale dopée selon le deuxième type de conductivité.

La portion semiconductrice de détection peut être réalisée à base de germanium, et la portion latérale être réalisée à base de silicium, l'étape de recuit assurant en outre une diffusion du silicium depuis la portion latérale vers la portion semiconductrice de détection, formant ainsi dans la portion semiconductrice de détection une zone latérale réalisée à base de silicium germanium.

Le procédé peut comporter les étapes suivantes :
- réalisation d'un empilement réalisé en un matériau semiconducteur d'intérêt, formé d'une sous-couche inférieure dopée selon le deuxième type de conductivité et d'une sous-couche intermédiaire ;
- réalisation d'une tranchée s'étendant au travers de l'empilement des sous-couches inférieure et intermédiaire, définissant ainsi la portion semiconductrice de détection de la photodiode ;
- réalisation simultanée de la portion latérale et la portion périphérique par dépôt d'un matériau semiconducteur dopé selon le deuxième type de conductivité dans l'ouverture traversante de la couche de passivation et dans la tranchée.

Le procédé peut comporter une étape de réalisation d'au moins une portion réfléchissante, située au contact de la portion périphérique sur une face opposée à la portion semiconductrice de détection, réalisée en un matériau réfléchissant vis-à-vis du rayonnement lumineux incident destiné à être détecté par la photodiode.

La portion réfléchissante peut être obtenue par dépôt d'une couche réalisée en un matériau métallique sur la portion périphérique, celle-ci étant réalisée à base de silicium, suivi d'un recuit de siliciuration formant ainsi une portion réfléchissante réalisée en le matériau métallique alors siliciuré.

L'étape de réalisation de la région supérieure dopée peut comporter les sous-étapes suivantes :
- réalisation d'une portion centrale réalisée en un matériau semiconducteur dopé selon le premier type de conductivité, disposée dans une ouverture traversante dite centrale de la couche de passivation située dans la partie centrale, et au contact de la première face ;
- recuit, assurant la diffusion d'éléments dopants selon le premier type de conductivité depuis la portion centrale vers la portion semiconductrice de détection, formant ainsi la région supérieure.

L'étape de réalisation de la portion centrale peut comporter les sous-étapes suivantes :
- dépôt dans l'ouverture traversante centrale d'un matériau semiconducteur dopé selon le deuxième type de conductivité, identique à celui de la portion périphérique ;
- implantation ionique, dans la portion centrale, d'éléments dopants selon le premier type de conductivité.

L'invention porte également sur une photodiode planaire passivée, comportant :
o une portion semiconductrice dite de détection, présentant une première et une deuxième faces opposées l'une à l'autre et parallèles à un plan principal de la photodiode, comportant :
   - une région supérieure dopée selon un premier type de conductivité et affleurant la première face,
   - une région inférieure dopée selon un deuxième type de conductivité opposé au premier type, et affleurant la deuxième face,
   - une région intermédiaire située entre les régions supérieure et inférieure et entourant la région supérieure dans le plan principal,
∘ une couche de passivation recouvrant la première face, comportant des ouvertures traversantes remplies chacune d'une portion périphérique, réalisée en un matériau semiconducteur contenant des éléments dopants selon le deuxième type de conductivité, et reposant sur et au contact de la première face au travers de l'ouverture traversante ;
∘ une portion latérale réalisée en un matériau semiconducteur dopé selon le deuxième type de conductivité et destinée à être polarisée électriquement, située au contact de la région inférieure et pouvant entourer la portion semiconductrice de détection dans le plan principal
la portion semiconductrice de détection comportant une région périphérique, dopée selon le deuxième type de conductivité, affleurant la première face et entourant la région supérieure dans le plan principal, et située entre, et à une distance non nulle, de la région supérieure et de la portion latérale.

La photodiode peut comporter une portion périphérique, réalisée en un matériau semiconducteur dopé selon le deuxième type de conductivité, située au contact de la région périphérique au travers d'une ouverture traversante de la couche de passivation.

La photodiode peut comporter une portion centrale, réalisée en un matériau semiconducteur dopé selon le premier type de conductivité, située au contact de la région supérieure au travers d'une ouverture traversante de la couche de passivation.

La portion périphérique et la portion centrale peuvent être revêtues d'une portion réfléchissante réalisée en un matériau métallique siliciuré.

La photodiode peut comporter une portion latérale, dopée selon le deuxième type de conductivité, au contact et entourant la portion semiconductrice de détection dans le plan principal, et dans laquelle la portion semiconductrice de détection comporte une région latérale, dopée selon le deuxième type de conductivité, et au contact de la portion latérale.

La portion semiconductrice de détection peut être réalisée à base de germanium et la portion latérale être réalisée à base de silicium, la portion semiconductrice de détection pouvant alors comporter une zone latérale réalisée à base de silicium germanium, et au contact de la portion latérale.

L'invention porte également sur un dispositif optoélectronique comportant une matrice de photodiodes selon l'une quelconque des caractéristiques précédentes, dans lequel les photodiodes sont coplanaires suivant le plan principal.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A et 1B sont des vues schématiques et partielles, en coupe, d'une photodiode planaire passivée selon deux modes de réalisation ;
les figures 2A à 2L illustrent, de manière schématique et partielle, différentes étapes d'un procédé de fabrication de photodiodes selon une variante du mode de réalisation illustré sur la fig.iB ;
les figures 3A et 3B sont des vues schématiques et partielles, en vue de dessus, d'une matrice de photodiodes selon deux variantes de réalisation, et la figure 3C est une vue schématique et partielle, en coupe, d'une photodiode planaire passivée selon un autre mode de réalisation.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près.

L'invention porte d'une manière générale sur un procédé de fabrication d'au moins une photodiode planaire passivée, et de préférence d'une matrice de photodiodes. Chaque photodiode est de préférence réalisée à base de germanium et est adaptée à détecter un rayonnement lumineux dans le proche infrarouge (SWIR, pour *Short Wavelength IR*, en anglais) correspondant à la gamme spectrale allant de 0,8µm à 1,7µm environ, voire à 2,5µm environ.

Les photodiodes sont dites planaires dans la mesure où elles s'étendent suivant un même plan principal, entre des première et deuxième faces parallèles et opposées l'une à l'autre. Elles comportent chacune une portion semiconductrice dite de détection, au sein de laquelle est présente une jonction PN ou PIN, présentant une épaisseur sensiblement constante entre les première et deuxième faces. Chaque photodiode comporte une première région dopée selon un premier type de conductivité, par exemple de type n, affleurant la première face et formant un caisson dopé, une deuxième région dopée selon un deuxième type de conductivité, par exemple de type p, affleurant la deuxième face, et une région intermédiaire située entre les deux régions dopées et entourant la première région dopée dans le plan principal. Cette région intermédiaire peut être dopée selon le deuxième type de conductivité, par exemple de type p, pour former une jonction PN, ou être intrinsèque, c'est-à-dire non intentionnellement dopée, pour former une jonction PIN. Les photodiodes planaires ne présentent alors pas une structure en mesa, et sont isolées optiquement les unes des autres, soit par des tranchées remplies avantageusement par un matériau semiconducteur dopé, soit par une distance suffisante séparant les photodiodes les unes des autres. Par ailleurs, la photodiode est dite passivée dans la mesure où la première face est recouverte, ici partiellement, par une couche de passivation réalisée en un matériau diélectrique. La couche de passivation est notamment destinée à réduire la composante de surface du courant d'obscurité de chaque photodiode.

D'une manière générale, le courant d'obscurité d'une photodiode est le courant électrique présent au sein de la photodiode en fonctionnement, lorsqu'elle n'est pas soumise à un rayonnement lumineux. Il peut être formé de courants générés thermiquement à l'intérieur du volume de la portion semiconductrice de détection (courants de diffusion, courants de déplétion, courants tunnels...) et de courants de surface. Les courants de surface peuvent être liés à la présence de charges électriques dans la couche de passivation. En effet, ces charges électriques peuvent induire une modification de la courbure des bandes d'énergie à proximité de la surface, conduisant à la formation d'une zone déplétée ou d'une zone d'inversion. La zone déplétée, lorsqu'elle est située dans la zone de charge d'espace de la photodiode, peut donner lieu à des courants parasites de type génération-recombinaison. Par ailleurs, la zone d'inversion, alors électriquement conductrice, peut permettre le déplacement de charges électriques entre des régions polarisées dopées n et p et situées à l'interface avec la couche de passivation.

Le procédé de fabrication permet ainsi d'obtenir une ou plusieurs photodiodes planaires passivées comportant, pour chaque photodiode, au moins une région périphérique de la portion semiconductrice de détection, dopée selon le deuxième type de conductivité (par ex. de type p), affleurant la première face et entourant la première région dopée dans le plan principal. Cette région périphérique permet notamment de limiter ou d'éviter la formation d'une zone déplétée ou d'une zone d'inversion et donc permet de limiter les courants parasites de surface associés à la courbure des bandes d'énergie.

Par ailleurs, dans le cas où les photodiodes sont isolées optiquement les unes des autres par des tranchées remplies d'un matériau semiconducteur dopé, et sont polarisées en inverse à partir de la première face, la région périphérique permet en outre de limiter ou d'éviter la formation du courant parasite de surface associé au déplacement des charges électriques (court-circuit électrique) à l'interface avec la couche de passivation entre la première région dopée et les tranchées semiconductrices dopées.

Ainsi, le procédé de fabrication permet d'obtenir une ou des photodiodes à courant d'obscurité réduit. Comme il est détaillé par la suite, la région périphérique est obtenue sans provoquer une modification sensible des caractéristiques de la portion semiconductrice de détection, et plus précisément sans induire une modification des dimensions de la première région dopée.

Pour des raisons de clarté, on illustrera tout d'abord une photodiode planaire passivée obtenue par le procédé de fabrication selon un mode de réalisation.

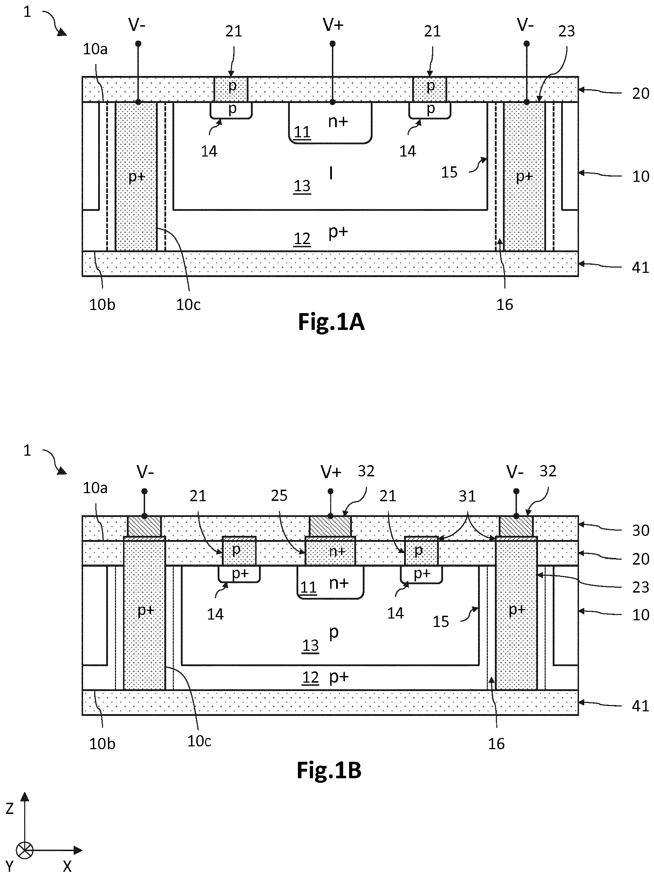

La figure 1A est une vue partielle et schématique, en coupe transversale, d'une telle photodiode 1 planaire passivée appartenant à une matrice de photodiodes. Dans cet exemple, les photodiodes 1 sont réalisées à base de germanium. Elles sont polarisées en inverse à partir de la première face 10a et sont optiquement isolées les unes des autres par des tranchées remplies d'un matériau semiconducteur dopé.

On définit ici et pour la suite de la description un repère direct tridimensionnel (X,Y,Z), où les axes X et Y forment un plan parallèle au plan principal des photodiodes 1, et où l'axe Z est orienté suivant l'épaisseur de la portion semiconductrice de détection 10 de la photodiode 1, à partir de la deuxième face 10b en direction de la première face 10a.

La photodiode 1 comporte une portion semiconductrice de détection 10 s'étendant suivant l'axe Z entre une première et une deuxième faces 10a, 10b parallèles et opposées l'une à l'autre. Les première et deuxième faces 10a, 10b sont communes à chaque photodiode 1 de la matrice. Elles peuvent être sensiblement planes, de sorte que la portion semiconductrice de détection 10 présente une épaisseur suivant l'axe Z sensiblement constante, par exemple comprise entre quelques centaines de nanomètres et quelques microns, par exemple comprise entre 1µm et 5µm environ. L'épaisseur est choisie de manière à obtenir une bonne absorption dans la gamme de longueurs d'onde du rayonnement lumineux à détecter. La portion semiconductrice de détection 10 présente une dimension transversale dans le plan XY pouvant être comprise entre quelques centaines de nanomètres et quelques dizaines de microns, par exemple comprise entre µm et 20µm environ.

La portion semiconductrice de détection 10 est réalisée en au moins un matériau semiconducteur cristallin, de préférence monocristallin. Elle est par ailleurs réalisée à base d'un élément chimique d'intérêt, ici à base de germanium. Par à base de, on entend que le matériau semiconducteur cristallin correspond à l'élément chimique d'intérêt ou est un alliage formé d'au moins l'élément chimique d'intérêt. L'élément chimique d'intérêt est avantageusement du germanium, de sorte que les photodiodes 1 sont réalisées en germanium Ge, en silicium germanium SiGe, le germanium étain GeSn, et le silicium germanium étain SiGeSn. Dans cet exemple, la portion semiconductrice de détection 10 est issue d'au moins une couche réalisée en le même élément chimique d'intérêt, à savoir ici en germanium. Elle peut ainsi être une couche ou un substrat réalisé en le même matériau semiconducteur et présenter des régions de différents types de conductivité (homojonction) de manière à former une jonction PN ou PIN. Elle peut en variante être un empilement de sous-couches de différents matériaux semiconducteurs (hétérojonction), lesquels sont alors formés à base de l'élément chimique d'intérêt.

La portion semiconductrice de détection 10 est ainsi formée d'une première région 11 dopée selon un premier type de conductivité, ici de type n, qui affleure la première face 10a et forme un caisson dopé n, et une deuxième région 12 dopée selon un deuxième type de conductivité, ici de type p, qui affleure la deuxième face 10b. Par affleurer, on entend « arriver au niveau de », ou « s'étend à partir de ». Une région intermédiaire 13 intrinsèque (dans le cas d'une jonction PIN), ou dopée selon le deuxième type de conductivité (dans le cas d'une jonction PN), est située entre et au contact des deux régions dopées 11, 12, et entoure la première région 11 dopée n dans le plan principal. Dans cet exemple, la jonction semiconductrice est de type PIN, la première région 11 étant dopée de type n+, la deuxième région 12 dopée de type p+ et la région intermédiaire 13 est intrinsèque (non intentionnellement dopée).

La première région 11 dopée n+ s'étend ici à partir de la première face 10a et est entourée parla région intermédiaire 13 dans le plan principal. Elle est distante de la bordure latérale 10c de la portion semiconductrice de détection 10 dans le plan XY, la bordure latérale 10c reliant les première et deuxième faces 10a, 10b entre elles. Elle forme ainsi un caisson dopé n qui affleure la première face 10a et est espacée d'une distance non nulle vis-à-vis de la bordure latérale 10c ainsi que de la deuxième face 10b. La première région 11 dopée n participe ainsi à délimiter la première face 10a. Elle peut présenter un dopage pouvant être compris entre 10¹⁹ et 10²¹ at/cm3 environ.

La deuxième région 12 dopée ici p+ s'étend dans le plan XY en affleurant la deuxième face 10b, ici à partir de la bordure latérale 10c. Elle s'étend suivant l'axe Z à partir de la deuxième face 10b. Elle peut présenter une épaisseur sensiblement homogène suivant l'axe Z et ainsi affleurer uniquement une zone inférieure de la bordure latérale 10c. En variante, comme illustré sur les fig.1A et 1B, la deuxième région 12 dopée p+ peut présenter une région latérale 15 dopée p+ qui affleure continûment la bordure latérale 10c suivant l'axe Z et s'étend sur toute la périphérie de la portion semiconductrice de détection 10. La deuxième région 12 dopée p+ peut présenter un dopage pouvant être compris entre 10¹⁸ et 10²⁰ at/cm3 environ.

La région intermédiaire 13 est située entre les deux régions 11, 12 dopées n+ et p+. Elle entoure donc la première région 11 dopée n+ dans le plan XY et peut affleurer localement la première face 10a. Elle est ici intrinsèque de manière à former une jonction PIN mais peut être dopée selon le deuxième type de conductivité, par exemple de type p, pour former une jonction PN (cf. fig.1B).

Le dispositif optoélectronique comporte ici une couche isolante inférieure 41, réalisée en un matériau diélectrique, recouvrant la deuxième face 10b de la portion semiconductrice de détection 10, ainsi que, comme décrit plus loin, la face inférieure d'une tranchée remplie d'un matériau semiconducteur dopé. La tranchée semiconductrice dopée participe à polariser électriquement la photodiode 1, ici à partir de la première face 10a, et à pixelliser la matrice de photodiodes (isolation optique). La couche isolante inférieure 41 peut en outre être adaptée à former une fonction d'antireflet vis-à-vis du rayonnement lumineux incident. Elle forme en effet la face de réception du rayonnement lumineux destiné à être détecté.

La portion semiconductrice de détection 10 de la photodiode 1 est ici délimitée latéralement, dans le plan XY, par une tranchée, de préférence continue, remplie d'un matériau semiconducteur dopé selon le deuxième type de conductivité, et formant ici une portion latérale 23 semiconductrice dopée p+. La tranchée s'étend ici sur toute l'épaisseur de la portion semiconductrice de détection 10 pour déboucher sur la couche isolante inférieure 41. La portion latérale 23 dopée p+ est alors en contact avec la bordure latérale 10c de la portion semiconductrice de détection 10. En variante, la tranchée peut ne pas déboucher sur la couche isolante inférieure 41 et peut se terminer dans la deuxième région 12 dopée p+. Le matériau semiconducteur est de préférence réalisé à base de silicium, par exemple du silicium amorphe, du silicium polycristallin, du silicium germanium, voire peut être réalisé en germanium amorphe.

La couche de passivation 20 recouvre la première face 10a de la portion semiconductrice de détection 10. Elle peut ainsi être au contact de la région intermédiaire 13 lorsque celle-ci affleure la première face 10a, et peut être au contact de la première région 11 dopée n+. Elle est réalisée en un matériau diélectrique, tel qu'un oxyde de silicium, un nitrure de silicium, ou un oxynitrure de silicium. D'autres matériaux diélectriques peuvent être utilisés, tels qu'un oxyde de hafnium ou d'aluminium, voire un nitrure d'aluminium, entre autres. Elle présente une épaisseur par exemple comprise entre 50nm et 500nm.

La couche de passivation 20 a notamment pour rôle de réduire le courant d'obscurité en surface de la portion semiconductrice de détection 10. Cependant, il apparaît que la technique de dépôt de passivation utilisée peut participer à générer une contribution surfacique du courant d'obscurité. En effet, comme l'indique l'article de Sood et al. 2011 mentionné précédemment, la couche de passivation 20 peut induire la formation d'une zone déplétée dans la région intermédiaire 13 à partir de la première face 10a. Lorsque cette zone déplétée est située dans la zone de charge d'espace de la photodiode 1, elle peut alors être le lieu d'un courant parasite de génération-recombinaison. Par ailleurs, la couche de passivation 20 peut former une zone d'inversion, alors électriquement conductrice, qui peut donc connecter la première région 11 dopée n+ à la portion latérale 23 dopée p+.

Aussi, chaque photodiode 1 comporte une région périphérique 14 dopée selon le deuxième type de conductivité, ici de type p, affleurant la première face 10a et entourant la première région 11 dopée n+ dans le plan XY. Par entourer, on entend que la région périphérique 14 dopée p s'étend autour de la première région 11 dopée n+ dans le plan principal, de manière continue ou éventuellement discontinue. La région périphérique 14 s'étend ainsi suivant l'axe Z à partir de la première face 10a, et s'étend dans le plan XY au moins en partie autour de la première région 11 dopée n+. Elle est située à une distance non nulle de la première région 11 dopée n+, ou en variante peut venir au contact de celle-ci. Elle est également située à une distance non nulle de la portion latérale 23 dopée p+, ou en variante peut venir au contact de celle-ci. La région périphérique 14 dopée p peut présenter un niveau de dopage de l'ordre de 10¹⁶ à 10¹⁸ at/cm3, supérieur à celui de la région intermédiaire 13 lorsqu'elle est dopée p. Les éléments dopants de type p peuvent être choisis parmi le bore et le gallium, entre autres. Comme décrit en détail plus loin, la région périphérique 14 dopée p est formée lors d'un recuit assurant la diffusion des éléments dopants depuis la portion périphérique 21 dopée p, située au contact de la première face 10a et s'étendant au travers d'ouvertures traversantes de la couche de passivation 20, vers la portion semiconductrice de détection 10.

Ainsi, la présence de la région périphérique 14 dopée p dans la région intermédiaire 13, au niveau de la première face 10a et s'étendant au moins en partie autour de la première région 11 dopée n+ dans le plan XY, permet d'éviter la présence d'une zone déplétée voire d'une zone d'inversion au niveau de la première face 10a. En outre, elle permet d'éviter que la zone de charge d'espace de la photodiode 1 ne se « pince » ou ne s'étende excessivement au niveau de la première face 10a. Une zone de charge d'espace « pincée », c'est-à-dire qui se réduit au niveau de la première face 10a, peut favoriser les courants tunnels. Une zone de charge d'espacée étendue de manière excessive peut favoriser le courant de type génération-recombinaison. Ainsi, on évite qu'un courant parasite de type génération-recombinaison ou de type tunnel ne se forme au niveau de la première face 10a, et on évite également la formation d'un courant parasite entre la première région 11 dopée n+ et la portion latérale 23 dopée p+. On réduit ainsi les composantes de surface du courant d'obscurité, ce qui permet d'améliorer les performances de la matrice de photodiodes.

Par ailleurs, la portion semiconductrice de détection 10 comporte avantageusement une région latérale 15 dopée selon le deuxième type de conductivité, ici de type p+, située au niveau de la bordure latérale 10c. Cette région latérale 15 présente un niveau de dopage supérieur à celui de la région intermédiaire 13 lorsqu'elle est dopée. La région latérale 15 dopée p+ affleure la bordure latérale 10c et est au contact de la portion latérale 23 dopée p+. Ainsi, la polarisation de la deuxième région 12 dopée p+ est améliorée dans la mesure où la surface de contact avec la portion latérale 23 dopée p+ est augmentée. De plus, cette région latérale 15 dopée p+ permet d'éviter que la zone de charge d'espace de la photodiode 1 ne s'étende jusqu'à la bordure latérale 10c. Ainsi, on limite la contribution de cette zone (potentiellement non exempte de défauts liés à la réalisation des tranchées) au courant d'obscurité. On améliore ainsi les performances de la photodiode 1.

Par ailleurs, la portion semiconductrice de détection 10 est réalisée à base de germanium, par exemple en germanium, et la portion latérale 23 dopée p+ est réalisée à base de silicium, par exemple en silicium polycristallin dopé. La portion semiconductrice de détection 10 comporte alors avantageusement une zone latérale 16 réalisée à base de silicium germanium, laquelle peut être formée lors du recuit de diffusion utilisé pour réaliser la région périphérique 14 dopée p. La zone latérale 16 affleure la bordure latérale 10c et est au contact de la portion latérale 23 dopée p+. Ainsi, la zone latérale 16 présente une énergie de bande interdite (gap) supérieure à celle de la portion semiconductrice de détection 10 réalisée en germanium. Cette « ouverture de gap » latérale permet de diminuer la sensibilité de la photodiode 1 aux défauts présents à proximité des tranchées. On améliore ainsi également les performances de la photodiode 1.

La photodiode 1 comporte en outre un circuit électrique permettant de polariser en inverse chaque photodiode 1. Dans cet exemple, le circuit électrique permet de polariser la photodiode 1 à partir de la première face 10a. Comme détaillé plus loin, le circuit électrique peut comporter des métallisations de contact s'étendant au travers d'ouvertures traversantes de la couche de passivation 20 et venant au contact de la première région 11 dopée n+ d'une part, et de la portion latérale 23 dopée p+ d'autre part.

A ce titre, la figure 1B une vue partielle et schématique, en coupe transversale, d'une photodiode 1 planaire passivée appartenant à une matrice de photodiodes, obtenue par le procédé de fabrication selon un autre mode de réalisation. Les photodiodes 1 se distinguent ici de celles décrites en référence à la fig.iA essentiellement en ce que la jonction semiconductrice est de type PN. La région intermédiaire 13 est alors dopée ici de type p et la deuxième région est dopée de type p+.

Une portion centrale 25, réalisée en un matériau semiconducteur dopé n, est ici située en regard, c'est-à-dire à la perpendiculaire, de la première région 11 dopée n+ et participe à assurer la polarisation de celle-ci. Comme décrit en détail plus loin, cette portion centrale 25 est utilisée pour réaliser la première région 11 dopée n+ dans la portion semiconductrice de détection 10. En effet, la première région 11 dopée n+ est formée par une diffusion des éléments dopants de type n, par exemple du phosphore, arsenic, antimoine, contenu dans la portion centrale 25. Cela permet d'éviter de former la première région 11 dopée n+ par implantation ionique d'éléments dopants de type n (phosphore par ex.) directement dans la portion semiconductrice de détection 10. On évite ainsi la formation de défauts pouvant provenir de l'implantation ionique dans le germanium de la portion semiconductrice de détection 10. On améliore ainsi également les performances de la photodiode 1.

Une couche isolante supérieure 30 recouvre la couche de passivation 20. Elle permet d'assurer un assemblage mécanique et une connexion électrique de la matrice de photodiodes avec une puce de commande (non représentée). La couche isolante supérieure 30 est réalisée en un matériau diélectrique, par exemple un oxyde ou un nitrure de silicium, voire un oxyde d'aluminium ou d'hafnium, entre autres. Elle comporte des ouvertures traversantes situées en regard de la première région 11 dopée n+ et de la portion latérale 23 dopée p+. Elles sont remplies chacune d'une métallisation de contact 32, qui vient au contact ici d'une mince portion réfléchissante et conductrice 31, ici réalisée en un siliciure de nickel, présentant une faible résistivité électrique et assurant également un rôle de réflecteur vis-à-vis du rayonnement lumineux incident provenant de la deuxième face 10b (celle-ci jouant le rôle de face de réception optique). On améliore ainsi la proportion absorbée du rayonnement lumineux incident dans la portion semiconductrice de détection. Les métallisations de contact 32 sont en contact électrique avec la portion latérale 23 et avec la région supérieure 11 (ici via la portion centrale 25) de manière à polariser la photodiode en inverse.

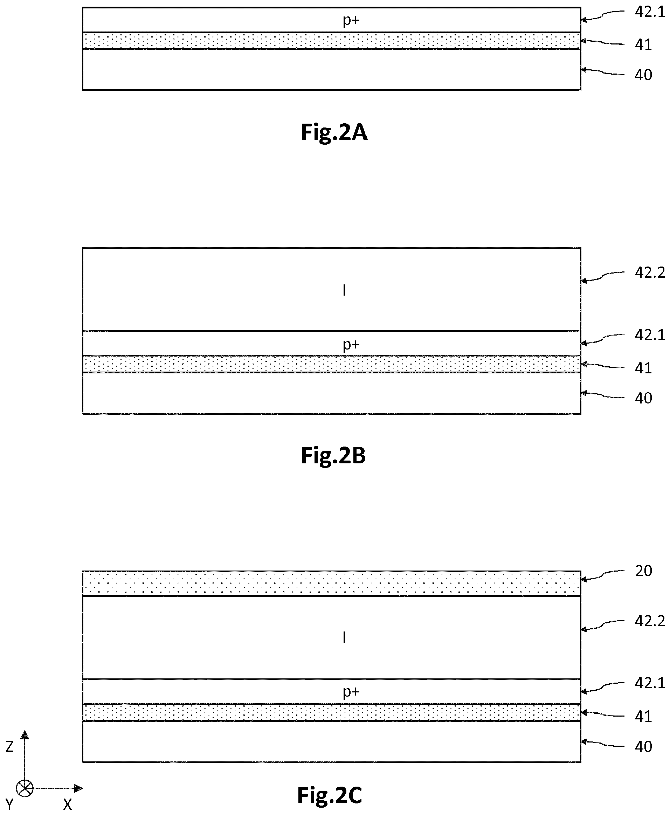

Un exemple de procédé de fabrication d'une matrice de photodiodes selon une variante du mode de réalisation illustré sur la fig.iB est maintenant décrit en référence aux figures 2A à 2L. Dans cet exemple, les photodiodes 1 sont réalisées en germanium et comportent une jonction PIN, et sont adaptées à détecter un rayonnement infrarouge dans la gamme SWIR. Les photodiodes 1 sont planaires et passivées, et sont polarisées en inverse à partir de la première face 10a.

Lors d'une première étape (fig.2A), on réalise une première sous-couche semiconductrice 42.1 de germanium monocristallin. La première sous-couche semiconductrice 42.1 est solidarisée à une couche support 40, ici en silicium, par l'intermédiaire d'une couche isolante inférieure 41, ici en un oxyde de silicium. Cet empilement prend la forme d'un substrat GeOI (pour *Germanium On Insulator*, en anglais). Cet empilement est de préférence réalisé au moyen du procédé décrit dans la publication de Reboud et al. intitulée Structural and optical properties of 200mm germanium-on-insulator (GeOI) substrates for silicon photonics applications, Proc. SPIE 9367, Silicon Photonics X, 936714 (February 27, 2015). Un tel procédé présente l'avantage de réaliser une sous-couche semiconductrice 42.1 de germanium présentant une absence totale ou un faible taux de défauts structuraux tels que les dislocations. Le germanium peut être non intentionnellement dopé ou être dopé, par exemple de type p. La sous-couche semiconductrice 42.1 peut présenter une épaisseur comprise entre 20nm et 500nm environ, par exemple égale à 300nm environ, et peut être recouverte d'une couche de protection (non représentée) en un oxyde de silicium. La couche isolante inférieure 41 (BOX, pour *Buried Oxide*, en anglais) peut présenter une épaisseur comprise entre 50nm et 1µm et assure avantageusement une fonction d'antireflet.

On réalise ensuite un dopage de la première sous-couche 42.1 en germanium selon le deuxième type de conductivité, ici de type p, par implantation ionique d'un dopant tel que le bore ou le gallium, lorsque la première sous-couche 42.1 était initialement en germanium intrinsèque. La couche de protection, le cas échéant, a été préalablement retirée par un nettoyage de surface, et la première sous-couche 42.1 de germanium peut être revêtue d'une couche d'oxyde de préimplantation (non représentée) d'une épaisseur de quelques dizaines de nanomètres, par exemple égale à 20nm. La sous-couche 42.1 de germanium présente alors un niveau de dopage compris entre 10¹⁸ et 10²⁰ at/cm³ environ. Un recuit de diffusion du dopant peut ensuite être effectué sous azote, pendant quelques minutes à quelques heures, par exemple 1h, à une température pouvant être comprise entre 600°C et 800°C, par exemple égale à 800°C. Ce recuit peut ne pas être effectué lorsque la sous-couche 42.1 était dopée à la croissance.

Lors d'une étape suivante (fig.2B), on réalise une deuxième sous-couche semiconductrice 42.2 de germanium par épitaxie à partir de la première sous-couche 42.1. Les deux sous-couches 42.1, 42.2 sont destinées à former les portions semiconductrices de détection 10 coplanaires en germanium de la matrice de photodiodes. La deuxième sous-couche 42.2 est formée par épitaxie, par exemple par dépôt chimique en phase vapeur (CVD, pour *Chemical Vapor Deposition*, en anglais) ou par toute autre technique d'épitaxie. Des recuits peuvent être effectués pour diminuer le taux de dislocations dans la sous-couche 42.2. La couche d'oxyde de préimplémentation, le cas échéant, a été préalablement retirée par un nettoyage de surface. La deuxième sous-couche 42.2 de germanium est ici intrinsèque, c'est-à-dire non intentionnellement dopée. Elle est destinée à former la zone d'absorption lumineuse des photodiodes 1. Son épaisseur dépend de la gamme de longueurs d'onde du rayonnement lumineux à détecter dans le cas d'une photodiode 1. Dans le cadre de photodiodes SWIR, la sous-couche 42.2 de germanium intrinsèque présente une épaisseur par exemple comprise entre 0,5µm et 3µm, de préférence égale à 1,5µm.

Lors d'une étape suivante (fig.2C), on dépose la couche de passivation 20 de manière à recouvrir continûment la face supérieure de la deuxième sous-couche 42.2, c'est-à-dire de manière à recouvrir les portions semiconductrices de détection des photodiodes. La couche de passivation 20 est réalisée en un matériau diélectrique, par exemple un oxyde, un nitrure ou un oxynitrure de silicium. Un nettoyage de la face supérieure de la deuxième sous-couche 42.2 peut avoir été effectué. La couche de passivation 20 peut présenter une épaisseur comprise entre 10nm et 600nm.

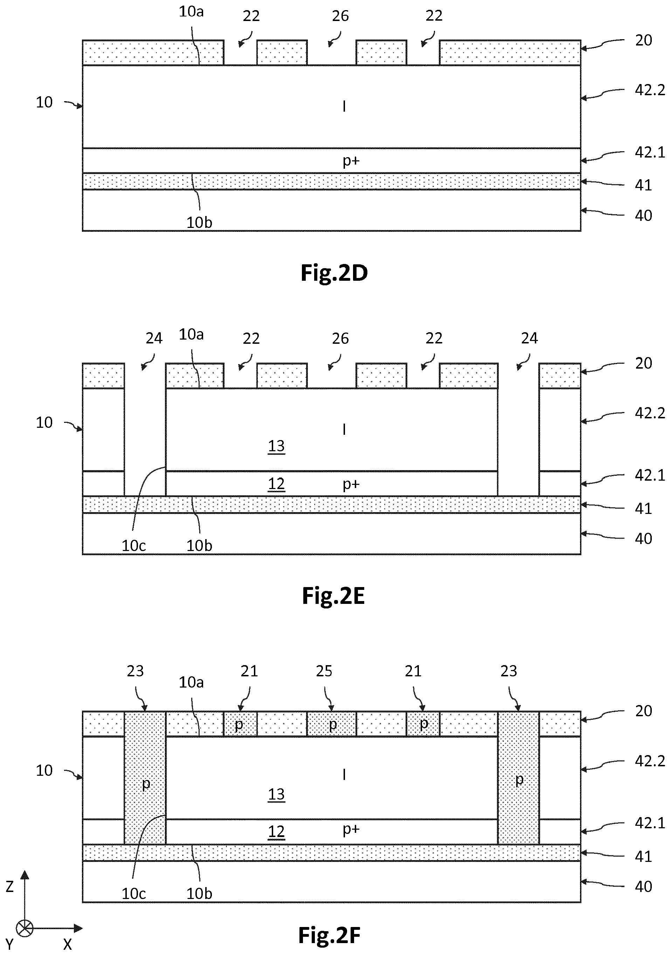

Lors d'une étape suivante (fig2D), on réalise, par photolithographie et gravure, les ouvertures traversantes 22 au sein de la couche de passivation 20. Les ouvertures traversantes 22 débouchent donc sur la face supérieure 10a de la portion semiconductrice de détection 10. Elles sont situées en regard des zones susceptibles de présenter un phénomène d'inversion (zone déplétée ou zone d'inversion), et entourent une partie centrale de la portion semiconductrice de détection 10 dans laquelle la première région 11 dopée n+ est destinée à être formée. Pour chaque photodiode, l'ouverture traversante 22 entoure continûment la partie centrale. Ces ouvertures traversantes 22 peuvent présenter différents motifs dans le plan XY, par exemple un motif de forme circulaire ou carrée. La largeur des ouvertures traversantes 22 dépend du pas des pixels sensibles de la matrice de photodiodes, et peut être comprise par exemple entre 1µm et 100µm.

On peut également réaliser dans le même temps des ouvertures traversantes 26 situées chacune en regard de la partie centrale des photodiodes. La largeur, par exemple le diamètre dans le cas d'une ouverture traversante 26 circulaire, dépend notamment de la largeur souhaitée de la première région 11 dopée n+. Elle peut être comprise entre 0.3µm et 5µm.

Lors d'une étape suivante (fig.2E), on réalise ensuite, par photolithographie et gravure, les tranchées 24 destinées à pixelliser les photodiodes 1 et à participer à les polariser électriquement en inverse. On réalise ainsi une gravure localisée de la couche de passivation 20, de la sous-couche 42.2 de germanium intrinsèque, et de la sous-couche 42.1 de germanium dopé p+, jusqu'à déboucher sur la face supérieure de la couche isolante inférieure 41. Chaque tranchée 24 s'étend ainsi de préférence continûment autour d'une photodiode. On obtient ainsi une pluralité de portions semiconductrices de détection 10 séparées les unes des autres par une tranchée continue 24. Elles sont obtenues de préférence par une technique de gravure anisotrope, de manière à obtenir une bordure latérale 10c sensiblement verticale suivant l'axe Z. Les tranchées 24 présentent une dimension transversale (largeur) dans le plan XY pouvant être comprise entre 300nm et 2µm, par exemple égale à 1µm. Les portions semiconductrices de détection 10 peuvent ainsi présenter une forme dans le plan XY par exemple circulaire, ovale, polygonale, par exemple carrée, ou toute autre forme.

Lors d'une étape suivante (fig.2F), on réalise ensuite les portions périphériques 21, et avantageusement de manière simultanée, les portions latérales 23 et la portion centrale 25. Pour cela, on dépose un matériau semiconducteur dopé de manière à remplir les tranchées 24 ainsi que les ouvertures traversantes 22, 26. Le matériau semiconducteur est de préférence un matériau à base de silicium, par exemple du silicium amorphe, du silicium polycristallin, de silicium germanium, voire de germanium amorphe. Le matériau semiconducteur est dopé selon le deuxième type de conductivité, ici de type p au bore ou au gallium. Ainsi, un même matériau semiconducteur dopé, avantageusement réalisé à base de germanium, remplit les tranchées 24 et forme la portion latérale 23, et forme également la portion périphérique 21 et la portion centrale 25. Il vient ainsi au contact de la bordure latérale 10c par les tranchées, au contact de la face supérieure 10a de la portion semiconductrice de détection 10 par les ouvertures traversantes périphériques 22 d'une part et par l'ouverture traversante centrale 26 d'autre part. Une étape de polissage mécanochimique (CMP) est ensuite effectuée, avec arrêt sur la face supérieure de la couche de passivation 20, pour éliminer le matériau semiconducteur en excès et planariser la face supérieure formée par la couche de passivation 20 et le matériau semiconducteur. On obtient ainsi une portion latérale 23 dopée p dans les tranchées, une portion périphérique 21 dopée p entourant ici une portion centrale 25 dopée p.

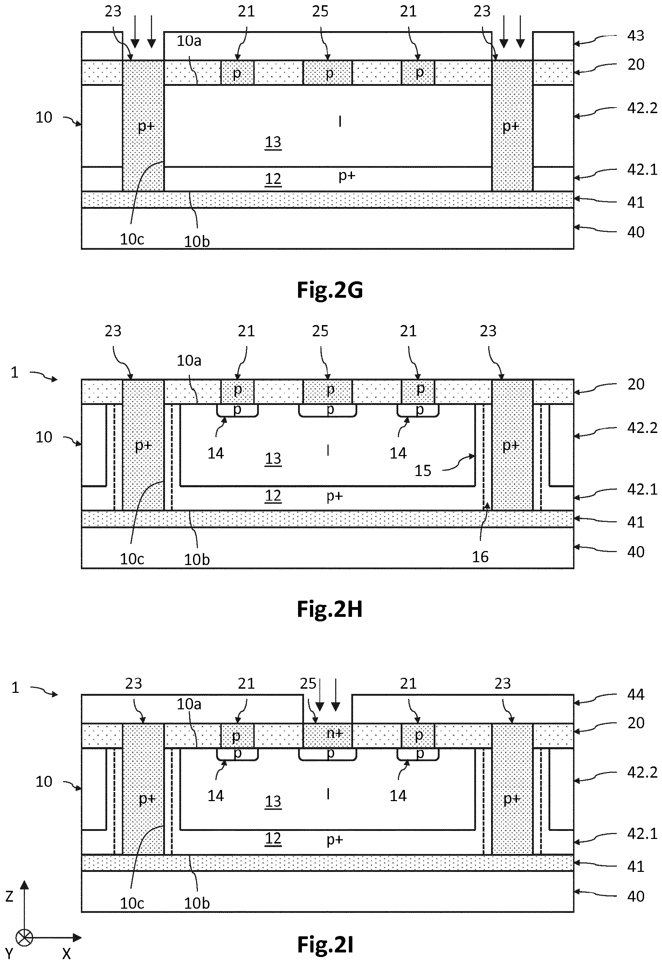

Lors d'une étape suivante (fig.2G), on effectue une implantation ionique d'éléments dopants de type p dans la portion latérale 23, par exemple de bore, de manière à obtenir une portion latérale 23 dopée p+ sur toute son épaisseur, avec un niveau de dopage par exemple compris entre 10¹⁹ et 10²¹ at/cm³. L'implantation ionique est réalisée de manière localisée au travers d'une ouverture traversante pratiquée dans une résine photosensible 43. On retire ensuite la résine photosensible 43.

Lors d'une étape suivante (fig.2H), on réalise les régions périphériques 14 dopées selon le deuxième type de conductivité, ici de type p, entourant une partie centrale destinée à recevoir la première région 11 dopée n+. Pour cela, on effectue un recuit de diffusion, par exemple à une température comprise entre 700°C et 800°C, pendant une durée par exemple comprise entre 10min et 5h, de manière à assurer la diffusion des éléments dopants, ici le bore, présents dans les portions périphériques 21 vers la région intermédiaire 13 au travers de la première face 10a. De manière simultanée, les régions latérales 15 dopées p+ sont également formées par diffusion des éléments dopants depuis les portions latérales 23 dopées p+ vers la région intermédiaire 13. Par ailleurs, de manière simultanée, la zone latérale 16 à ouverture de gap est formée par interdiffusion entre le germanium de la portion semiconductrice de détection 10 et le silicium de la portion latérale 23.

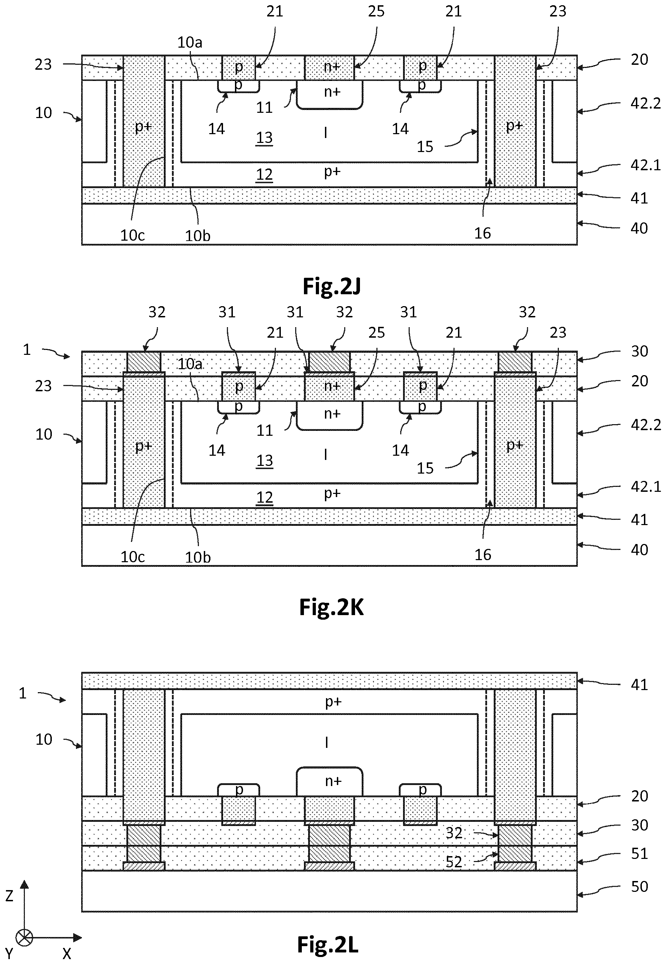

Lors d'une étape suivante (fig.2I et 2J), on réalise ensuite la première région 11 dopée selon le premier type de conductivité, ici de type n+. Pour cela, on définit une zone d'implantation ionique de dopants de type n, par exemple du phosphore ou de l'arsenic, ou de l'antimoine au moyen d'une ouverture traversante d'une résine photosensible 44. L'ouverture traversante est située en regard de la partie centrale de la photodiode 1 et présente des dimensions dans le plan XY correspondant aux dimensions souhaitées de la première région 11 dopée. Elles peuvent être comprises, par exemple entre 300nm et 90µm. On réalise la première portion 11 dopée n+ en deux temps : tout d'abord, on effectue une implantation ionique d'un dopant tel que le phosphore, au travers de l'ouverture de la résine 44, dans la portion centrale 25 initialement dopée p pour la rendre dopée n+. On peut ensuite supprimer la résine photosensible 44. On effectue au moins un recuit assurant la diffusion des éléments dopants n depuis la portion centrale 25 dopée n+ vers la portion semiconductrice de détection 10, par exemple à une première température de 800°C pendant 5min puis à une deuxième température comprise entre 600°C et 700°C pendant 10s à 60s. Par cette étape en deux temps, on limite ainsi les défauts liés à l'implantation ionique d'éléments dopants de type n directement dans la portion semiconductrice de détection 10.

Les premières régions 11 dopées n forment ainsi des caissons dopés délimités dans le plan XY et suivant la direction -Z par la région intermédiaire 13 de germanium intrinsèque. Elles sont de préférence surdopées n+, et peuvent ainsi présenter un niveau de dopage compris entre 10¹⁹ et 10²¹ at/cm³ environ. Ce nouveau recuit de diffusion provoque une diffusion supplémentaire du dopant de type p (bore) formant la portion périphérique 14 au sein du germanium. Cependant, la diffusion du bore étant inférieure à celle du phosphore, les dimensions de la région périphérique 14 dopée p et de la région latérale 15 dopée p+ ne sont sensiblement pas ou peu modifiées. On obtient ainsi une première région 11 dopée n+ au sein de la portion semiconductrice de détection 10, délimitée par la région intermédiaire 13 en germanium intrinsèque, et entourée dans le plan XY par la région périphérique 14 dopée p située au niveau de la première face 10a.

Lors d'une étape suivante (fig.2K), on réalise ensuite avantageusement les portions minces réfléchissantes 31, réalisées en un matériau électriquement conducteur et réflecteur pour le rayonnement lumineux incident. Ce matériau est de préférence un siliciure d'un métal de transition, par exemple un siliciure de nickel NiSi2. Pour cela, on dépose une couche mince continue de nickel Ni d'une épaisseur par exemple de 9nm, de manière à recouvrir continûment la face supérieure de la couche de passivation 20 et des portions dopées p réalisées à base de silicium, puis une couche mince continue de nitrure de titane TiN d'une épaisseur par exemple de 10nm. On effectue ensuite un recuit de siliciuration, par exemple de 300°C à 400°C pendant une durée de quelques dizaines de secondes, pour former des zones localisées 31 de NiSi₂ au contact des portions latérales 23, périphériques 21 et centrale 25. Une étape de gravure humide permet de supprimer les zones n'ayant pas siliciuré. On obtient ainsi des portions minces 31 conductrices et réflectrices de NiSi2.

On dépose ensuite une couche isolante supérieure 30 de manière à recouvrir la couche de passivation 20 ainsi que les portions minces réfléchissantes 31. La couche isolante supérieure 30 est réalisée en un matériau diélectrique, par exemple un oxyde, nitrure ou oxynitrure de silicium, un oxyde ou nitrure d'aluminium, un oxyde d'hafnium, entre autres. La couche isolante supérieure 30 peut présenter une épaisseur par exemple comprise entre 10nm et 500nm.

Enfin, on réalise des métallisations de contact 32, s'étendant au travers de la couche isolante supérieure 30, et venant au contact des portions minces réfléchissantes 31 situées en regard des portions latérales 23 et de la portion centrale 25. Ici, les portions périphériques 21 ne sont pas destinées à être polarisées, mais en variante, elles peuvent être polarisées de manière à modifier plus ou moins la zone de charge d'espace. Les métallisations de contact 32 peuvent être réalisées de manière classique, par remplissage des ouvertures traversant la couche isolante supérieure 30 d'au moins un matériau métallique (couche barrière à base de Ti, cœur en cuivre), suivi d'une étape de planarisation CMP.

Lors d'une étape suivante (fig.2L), on assure l'hybridation de l'empilement optoélectronique ainsi obtenu sur une puce de commande 50. La face de connexion de la puce de commande 50 peut ainsi être revêtue d'une couche isolante 51, réalisée en un matériau diélectrique, traversée par des métallisations de contact 52. L'empilement optoélectronique et la puce de commande 50 sont ainsi assemblés par adhésion moléculaire hybride, par contact des faces formées des métallisations de contact 32, 52 et des couches isolantes 30, 51. Un recuit de collage peut être effectué de manière à augmenter l'énergie de collage surfacique entre les deux faces en contact.

On réalise ensuite la suppression de la couche support 40, par exemple par abrasion (*grinding*, en anglais), de manière à exposer la couche isolante inférieure 41. Celle-ci forme ainsi la face de réception du rayonnement lumineux à détecter, et assure avantageusement une fonction d'antireflet.

Le procédé de fabrication permet ainsi d'obtenir une ou plusieurs photodiodes 1 planaires et passivées, dont les régions périphériques 14 entourant les premières régions 11 dopées permettent de limiter les composantes surfaciques du courant d'obscurité pouvant être liées à la couche de passivation 20.

De plus, dans la mesure où les régions périphériques 14 sont formées par diffusion de dopants à partir des portions périphériques 21 réalisées en un matériau semiconducteur dopé, et cela avant la formation par implantation ionique des premières régions dopées 11, le procédé de fabrication permet de préserver les dimensions de ces dernières. Ainsi, tout risque de court-circuit des photodiodes 1 par une modification excessive des dimensions des premières régions dopées 11 est ainsi écarté.

Par ailleurs, les performances des photodiodes 1 sont également améliorées notamment par les caractéristiques suivantes : la zone latérale 16 d'ouverture de gap située au niveau de la bordure latérale 10c, les régions latérales 15 dopées p situées au niveau de la bordure latérale 10c, les portions minces réfléchissantes 31, les premières régions dopées 11 obtenues par diffusion de dopants et non pas par implantation ionique directement dans la portion semiconductrice de détection 10. Par ailleurs, le procédé de fabrication est simplifié lorsque les portions latérales 23, périphériques 21 et centrale 25 sont réalisées simultanément et en un même matériau semiconducteur dopé.

Des modes de réalisation particuliers viennent d'être décrits. Différentes variantes et modifications apparaîtront à l'homme du métier.

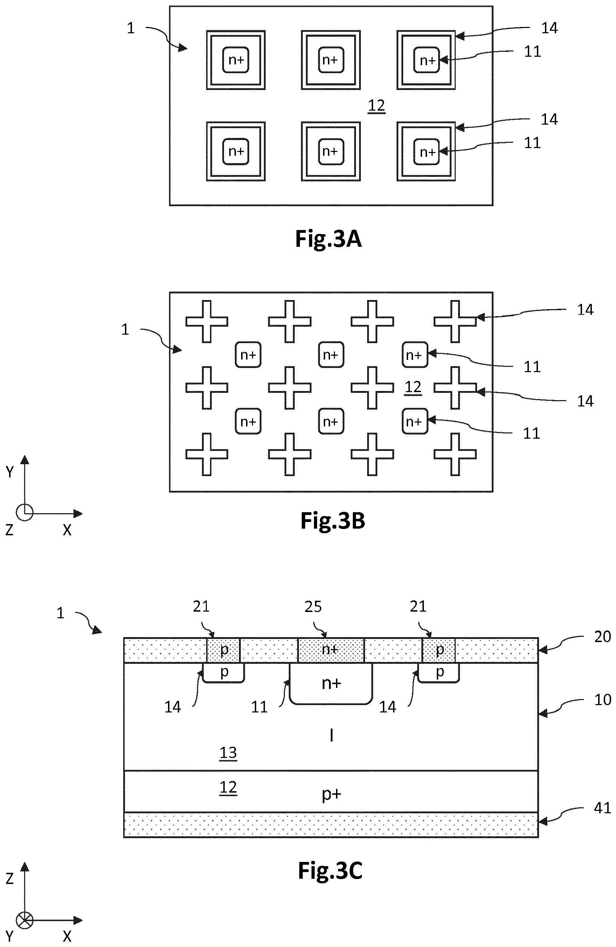

Ainsi, comme l'illustrent les figures 3A et 3B en vue de dessus, chacune des régions périphériques 14 peut s'étendre autour de la première région 11 dopée correspondante de manière continue (fig.3A) ou discontinue (fig.3B). Dans ce dernier cas, les portions périphériques 14 peuvent présenter différents motifs dans le plan XY, par exemple des motifs en forme de croix comme représenté ici, ou tout autre motif adapté.

Par ailleurs, comme l'illustre schématiquement la fig.3C en vue en coupe, le procédé de fabrication permet également d'obtenir une matrice de photodiodes 1 planaires passivées isolées optiquement les unes des autres par une distance suffisante dans le plan XY. Les photodiodes 1 ne sont alors pas pixellisées par des tranchées les entourant. Les premières régions 11 dopées n+ sont polarisées à partir de la première face 10a via des métallisations de contact (non représentées), et la deuxième région 12 dopée p+ peut être polarisée par une métallisation de contact située au niveau de la première face 10a et connectée à celle-ci par une tranchée conductrice, ou située au niveau de la deuxième face 10b.

## Revendications

1. Procédé de fabrication d'au moins une photodiode (1) planaire passivée, comportant les étapes suivantes :
i) réalisation d'une portion semiconductrice (10) dite de détection, présentant une première et une deuxième faces (10a, 10b) opposées l'une à l'autre et parallèles à un plan principal de la photodiode (1), et comportant :
o une région dite intermédiaire (13) affleurant la première face (10a),
o une région dite inférieure (12) dopée selon un deuxième type de conductivité et affleurant la deuxième face (10b),
ii) dépôt d'une couche de passivation (20), réalisée en un matériau diélectrique, recouvrant la première face (10a), et formation dans la couche de passivation (20) d'au moins une ouverture traversante (22) débouchant sur la première face (10a) et entourant au moins partiellement dans le plan principal une partie centrale de la portion semiconductrice de détection (10) ;
iii) réalisation d'une portion latérale (23) réalisée en un matériau semiconducteur dopé selon le deuxième type de conductivité et destinée à être polarisée électriquement, située au contact de la région inférieure (12) ;
**caractérisé en ce qu'**il comporte en outre les étapes suivantes :
iv) réalisation d'au moins une portion périphérique (21), réalisée en un matériau semiconducteur contenant des éléments dopants selon le deuxième type de conductivité, et reposant sur et au contact de la première face (10a) au travers de l'ouverture traversante (22) ;
v) recuit, assurant une diffusion des éléments dopants depuis la portion périphérique (21) vers la portion semiconductrice de détection (10), formant ainsi dans la portion semiconductrice de détection (10) une région périphérique (14) dopée selon le deuxième type de conductivité, affleurant la première face (10a) et entourant la partie centrale dans le plan principal, destinée à être située entre, et à une distance non nulle, d'une région dite supérieure (11) et de la portion latérale (23) ;
vi) réalisation, dans la partie centrale de la portion semiconductrice de détection (10), de la région supérieure (11) dopée selon un premier type de conductivité opposé au deuxième type et destinée à être polarisée électriquement, affleurant la première face (10a) et séparée de la région inférieure (12) par la région intermédiaire (13), et entourée dans le plan principal par la région périphérique (14).

2. Procédé selon la revendication 1, l'étape de recuit assurant en outre une diffusion d'éléments dopants selon le deuxième type de conductivité depuis la portion latérale (23) vers la portion semiconductrice de détection (10), formant ainsi dans la portion semiconductrice de détection (10) une région latérale (15) dopée selon le deuxième type de conductivité.

3. Procédé selon la revendication 1 ou 2, dans lequel la portion semiconductrice de détection (10) est réalisée à base de germanium, et la portion latérale (23) est réalisée à base de silicium, l'étape de recuit assurant en outre une diffusion du silicium depuis la portion latérale (23) vers la portion semiconductrice de détection (10), formant ainsi dans la portion semiconductrice de détection (10) une zone latérale (16) réalisée à base de silicium germanium.

4. Procédé selon l'une quelconque des revendications 1 à 3, comportant les étapes suivantes :
- réalisation d'un empilement réalisé en un matériau semiconducteur d'intérêt, formé d'une sous-couche inférieure (42.1) dopée selon le deuxième type de conductivité et d'une sous-couche intermédiaire (42.2) ;
- réalisation d'une tranchée (24) s'étendant au travers de l'empilement des sous-couches inférieure et intermédiaire (42.1, 42.2), définissant ainsi la portion semiconductrice de détection (10) de la photodiode (1) ;
- réalisation simultanée de la portion latérale (23) et la portion périphérique (21) par dépôt d'un matériau semiconducteur dopé selon le deuxième type de conductivité dans l'ouverture traversante (22) de la couche de passivation (20) et dans la tranchée (24).

5. Procédé selon l'une quelconque des revendications 1 à 4, comportant une étape de réalisation d'au moins une portion réfléchissante (31), située au contact de la portion périphérique (21) sur une face opposée à la portion semiconductrice de détection (10), réalisée en un matériau réfléchissant vis-à-vis du rayonnement lumineux incident destiné à être détecté par la photodiode (1).

6. Procédé selon la revendication 5, dans lequel la portion réfléchissante (31) est obtenue par dépôt d'une couche réalisée en un matériau métallique sur la portion périphérique (21), celle-ci étant réalisée à base de silicium, suivi d'un recuit de siliciuration formant ainsi une portion réfléchissante (31) réalisée en le matériau métallique alors siliciuré.

7. Procédé selon l'une quelconque des revendications 1 à 6, dans lequel l'étape de réalisation de la région supérieure dopée (11) comporte les sous-étapes suivantes :
- réalisation d'une portion centrale (25) réalisée en un matériau semiconducteur dopé selon le premier type de conductivité, disposée dans une ouverture traversante dite centrale (26) de la couche de passivation (20) située dans la partie centrale, et au contact de la première face (10a) ;
- recuit, assurant la diffusion d'éléments dopants selon le premier type de conductivité depuis la portion centrale (25) vers la portion semiconductrice de détection (10), formant ainsi la région supérieure (11).

8. Procédé selon la revendication 7, dans lequel l'étape de réalisation de la portion centrale (25) comporte les sous-étapes suivantes :
∘ dépôt dans l'ouverture traversante centrale (26) d'un matériau semiconducteur dopé selon le deuxième type de conductivité, identique à celui de la portion périphérique (21) ;
∘ implantation ionique, dans la portion centrale (25), d'éléments dopants selon le premier type de conductivité.

9. Photodiode (1) planaire passivée, comportant :
∘ une portion semiconductrice dite de détection (10), présentant une première et une deuxième faces (10a, 10b) opposées l'une à l'autre et parallèles à un plan principal de la photodiode (1), comportant :
• une région supérieure (11) dopée selon un premier type de conductivité et affleurant la première face (10a),
• une région inférieure (12) dopée selon un deuxième type de conductivité opposé au premier type, et affleurant la deuxième face (10b),
• une région intermédiaire (13) située entre les régions supérieure (11) et inférieure (12) et entourant la région supérieure (11) dans le plan principal,
∘ une couche de passivation (20) recouvrant la première face (10a), comportant des ouvertures traversantes (22) remplies chacune d'une portion périphérique (21), réalisée en un matériau semiconducteur contenant des éléments dopants selon le deuxième type de conductivité, et reposant sur et au contact de la première face (10a) au travers de l'ouverture traversante (22) ;
∘ une portion latérale (23) réalisée en un matériau semiconducteur dopé selon le deuxième type de conductivité et destinée à être polarisée électriquement, située au contact de la région inférieure (12) ;
**caractérisée en ce que** la portion semiconductrice de détection (10) comporte :
• une région périphérique (14), dopée selon le deuxième type de conductivité, affleurant la première face (10a) et entourant la région supérieure (11) dans le plan principal, et située entre, et à une distance non nulle, de la région supérieure (11) et de la portion latérale (23).

10. Photodiode (1) selon la revendication 9, comportant une portion centrale (25), réalisée en un matériau semiconducteur dopé selon le premier type de conductivité, située au contact de la région supérieure (11) au travers d'une ouverture traversante (26) de la couche de passivation (20).

11. Photodiode (1) selon la revendication 10, dans laquelle la portion périphérique (21) et la portion centrale (25) sont revêtues d'une portion réfléchissante (31) réalisée en un matériau métallique siliciuré.

12. Photodiode (1) selon l'une quelconque des revendications 9 à 11, comportant une portion latérale (23), dopée selon le deuxième type de conductivité, au contact et entourant la portion semiconductrice de détection (10) dans le plan principal, et dans laquelle la portion semiconductrice de détection (10) comporte une région latérale (15), dopée selon le deuxième type de conductivité, et au contact de la portion latérale (23).

13. Photodiode (1) selon la revendication 12, dans laquelle la portion semiconductrice de détection (10) est réalisée à base de germanium et la portion latérale (23) est réalisée à base de silicium, la portion semiconductrice de détection (10) comportant une zone latérale (16) réalisée à base de silicium germanium, et au contact de la portion latérale (23).

14. Dispositif optoélectronique comportant une matrice de photodiodes (1) selon l'une quelconque des revendications 9 à 13, dans lequel les photodiodes (1) sont coplanaires suivant le plan principal.

## Patentansprüche

1. Verfahren zur Herstellung mindestens einer passivierten planaren Fotodiode (1), das die folgenden Schritte umfasst:
i) Ausbilden eines sogenannten Detektionshalbleiterabschnitts (10), der eine erste und eine zweite Seite (10a, 10b) aufweist, die einander gegenüberliegen und zu einer Hauptebene der Fotodiode (1) parallel sind, und der Folgendes umfasst:
o eine sogenannte mittlere Region (13), die an die erste Seite (10a) angrenzt,
o eine sogenannte untere Region (12), die gemäß einem zweiten Leitfähigkeitstyp dotiert ist und an die zweite Seite (10b) angrenzt,
ii) Aufbringen einer Passivierungsschicht (20), die aus einem dielektrischen Material ausgebildet ist und die erste Seite (10a) überdeckt, und Bilden mindestens einer durchgehenden Öffnung (22) in der Passivierungsschicht (20), die an der ersten Seite (10a) mündet und in der Hauptebene einen mittigen Teil des Detektionshalbleiterabschnitts (10) mindestens teilweise umgibt;
iii) Ausbilden eines seitlichen Abschnitts (23), der aus einem gemäß dem zweiten Leitfähigkeitstyp dotierten Halbleitermaterial ausgebildet ist und dazu bestimmt ist, elektrisch polarisiert zu werden, der sich mit der unteren Region (12) in Kontakt befindet;
**dadurch gekennzeichnet, dass** es ferner die folgenden Schritte umfasst:
iv) Ausbilden mindestens eines peripheren Abschnitts (21), der aus einem Halbleitermaterial ausgebildet ist, das Dotierungselemente gemäß dem zweiten Leitfähigkeitstyp enthält und durch die durchgehende Öffnung (22) hindurch auf der ersten Seite (10a) aufliegt und sich mit dieser in Kontakt befindet;
v) Tempern, um eine Diffusion der Dotierungselemente von dem peripheren Abschnitt (21) in den Detektionshalbleiterabschnitt (10) zu bewirken, sodass in dem Detektionshalbleiterabschnitt (10) eine periphere Region (14) gebildet wird, die gemäß dem zweiten Leitfähigkeitstyp dotiert ist, die an die erste Seite (10a) angrenzt und den mittigen Teil in der Hauptebene umgibt und die dazu bestimmt ist, sich in einem Abstand ungleich null zwischen einer sogenannten oberen Region (11) und dem seitlichen Abschnitt (23) zu befinden;
vi) Ausbilden, in dem mittigen Teil des Detektionshalbleiterabschnitts (10), der oberen Region (11), die gemäß einem ersten Leitfähigkeitstyp, der dem zweiten Typ entgegengesetzt ist, dotiert ist und dazu bestimmt ist, elektrisch polarisiert zu werden, die an die erste Seite (10a) angrenzt und durch die mittlere Region (13) von der unteren Region (12) getrennt ist und die in der Hauptebene von der peripheren Region (14) umgeben ist.

2. Verfahren nach Anspruch 1, wobei der Schritt des Temperns ferner eine Diffusion von Dotierungselementen gemäß dem zweiten Leitfähigkeitstyp von dem seitlichen Abschnitt (23) in den Detektionshalbleiterabschnitt (10) bewirkt, sodass in dem Detektionshalbleiterabschnitt (10) eine seitliche Region (15) gebildet wird, die gemäß dem zweiten Leitfähigkeitstyp dotiert ist.

3. Verfahren nach Anspruch 1 oder 2, wobei der Detektionshalbleiterabschnitt (10) auf Basis von Germanium ausgebildet ist und der seitliche Abschnitt (23) auf Basis von Silizium ausgebildet ist, wobei der Schritt des Temperns ferner eine Diffusion des Siliziums von dem seitlichen Abschnitt (23) in den Detektionshalbleiterabschnitt (10) bewirkt, sodass in dem Detektionshalbleiterabschnitt (10) eine seitliche Zone (16) gebildet wird, die auf Basis von Silizium-Germanium ausgebildet ist.

4. Verfahren nach einem der Ansprüche 1 bis 3, das die folgenden Schritte umfasst:
- Ausbilden eines Stapels, der aus einem Halbleitermaterial von Interesse ausgebildet ist, gebildet aus einer unteren Teilschicht (42.1), die gemäß dem zweiten Leitfähigkeitstyp dotiert ist, und einer mittleren Teilschicht (42.2);
- Ausbilden eines Einschnitts (24), der sich durch den Stapel der unteren und der mittleren Teilschicht (42.1, 42.2) erstreckt, sodass der Detektionshalbleiterabschnitt (10) der Fotodiode (1) definiert wird;
- simultanes Ausbilden des seitlichen Abschnitts (23) und des peripheren Abschnitts (21) durch Aufbringen eines Halbleitermaterials, das gemäß dem zweiten Leitfähigkeitstyp dotiert ist, in der durchgehenden Öffnung (22) der Passivierungsschicht (20) und in dem Einschnitt (24).

5. Verfahren nach einem der Ansprüche 1 bis 4, das einen Schritt des Ausbildens mindestens eines reflektierenden Abschnitts (31) umfasst, der sich mit dem peripheren Abschnitt (21) auf einer dem Detektionshalbleiterabschnitt (10) gegenüberliegenden Seite in Kontakt befindet, ausgebildet aus einem Material, das für die einfallende Lichtstrahlung, die von der Fotodiode (1) detektiert werden soll, reflektierend ist.

6. Verfahren nach Anspruch 5, wobei der reflektierende Abschnitt (31) durch das Aufbringen einer Schicht, die aus einem metallischen Material ausgebildet ist, auf dem peripheren Abschnitt (21) erhalten wird, wobei dieser auf Basis von Silizium ausgebildet ist, gefolgt von einer Silizierungstemperung, sodass ein reflektierender Abschnitt (31) gebildet wird, der aus dem dann silizierten metallischen Material ausgebildet ist.

7. Verfahren nach einem der Ansprüche 1 bis 6, wobei der Schritt des Ausbildens der dotierten oberen Region (11) die folgenden Unterschritte umfasst:
- Ausbilden eines mittigen Abschnitts (25), der aus einem gemäß dem ersten Leitfähigkeitstyp dotieren Halbleitermaterial ausgebildet ist, der in einer sogenannten mittigen durchgehenden Öffnung (26) der Passivierungsschicht (20), die sich in dem mittigen Teil befindet, angeordnet ist und sich in Kontakt mit der ersten Seite (10a) befindet;
- Tempern, um die Diffusion von Dotierungselementen gemäß dem ersten Leitfähigkeitstyp von dem mittigen Abschnitt (25) in den Detektionshalbleiterabschnitt (10) zu bewirken, sodass die obere Region (11) gebildet wird.

8. Verfahren nach Anspruch 7, wobei der Schritt des Ausbildens des mittigen Abschnitts (25) die folgenden Unterschritte umfasst:
∘ Aufbringen, in der mittigen durchgehenden Öffnung (26), eines gemäß dem zweiten Leitfähigkeitstyp dotierten Halbleitermaterials, das mit dem des peripheren Abschnitts (21) identisch ist;
∘ Ionenimplantation von Dotierungselementen gemäß dem ersten Leitfähigkeitstyp in dem mittigen Abschnitt (25).

9. Passivierte planare Fotodiode (1), die Folgendes umfasst:
∘ einen sogenannten Detektionshalbleiterabschnitt (10), der eine erste und eine zweite Seite (10a, 10b) aufweist, die einander gegenüberliegen und zu einer Hauptebene der Fotodiode (1) parallel sind, umfassend:
• eine obere Region (11), die gemäß einem ersten Leitfähigkeitstyp dotiert ist und an die erste Seite (10a) angrenzt,
• eine untere Region (12), die gemäß einem zweiten Leitfähigkeitstyp dotiert ist, der dem ersten Typ entgegengesetzt ist, und an die zweite Seite (10b) angrenzt,
• eine mittlere Region (13), die sich zwischen der oberen (11) und der unteren (12) Region befindet und die obere Region (11) in der Hauptebene umgibt,
∘ eine Passivierungsschicht (20), die die erste Seite (10a) überdeckt, die durchgehende Öffnungen (22) umfasst, die jeweils mit einem peripheren Abschnitt (21) ausgefüllt sind, der aus einem Halbleitermaterial ausgebildet ist, das Dotierungselemente gemäß dem zweiten Leitfähigkeitstyp enthält und durch die durchgehende Öffnung (22) hindurch auf der ersten Seite (10a) aufliegt und sich mit dieser in Kontakt befindet;
∘ einen seitlichen Abschnitt (23), der aus einem gemäß dem zweiten Leitfähigkeitstyp dotierten Halbleitermaterial ausgebildet ist und dazu bestimmt ist, elektrisch polarisiert zu werden, der sich mit der unteren Region (12) in Kontakt befindet;
**dadurch gekennzeichnet, dass** der Detektionshalbleiterabschnitt (10) Folgendes umfasst:
• eine periphere Region (14), die gemäß dem zweiten Leitfähigkeitstyp dotiert ist, die an die erste Seite (10a) angrenzt und die obere Region (11) in der Hauptebene umgibt und die sich in einem Abstand ungleich null zwischen der oberen Region (11) und dem seitlichen Abschnitt (23) befindet.

10. Fotodiode (1) nach Anspruch 9, umfassend einen mittigen Abschnitt (25), der aus einem gemäß dem ersten Leitfähigkeitstyp dotierten Halbleitermaterial ausgebildet ist und sich durch eine durchgehende Öffnung (26) der Passivierungsschicht (20) hindurch mit der oberen Region (11) in Kontakt befindet.

11. Fotodiode (1) nach Anspruch 10, wobei der periphere Abschnitt (21) und der mittige Abschnitt (25) mit einem reflektierenden Abschnitt (31) beschichtet sind, der aus einem silizierten metallischen Material ausgebildet ist.

12. Fotodiode (1) nach einem der Ansprüche 9 bis 11, umfassend einen seitlichen Abschnitt (23), der gemäß dem zweiten Leitfähigkeitstyp dotiert ist, der sich mit dem Detektionshalbleiterabschnitt (10) in Kontakt befindet und diesen in der Hauptebene umgibt, und wobei der Detektionshalbleiterabschnitt (10) eine seitliche Region (15) umfasst, die gemäß dem zweiten Leitfähigkeitstyp dotiert ist und sich mit dem seitlichen Abschnitt (23) in Kontakt befindet.

13. Fotodiode (1) nach Anspruch 12, wobei der Detektionshalbleiterabschnitt (10) auf Basis von Germanium ausgebildet ist und der seitliche Abschnitt (23) auf Basis von Silizium ausgebildet ist, wobei der Detektionshalbleiterabschnitt (10) eine seitliche Zone (16) umfasst, die auf Basis von Silizium-Germanium ausgebildet ist und mit dem seitlichen Abschnitt (23) in Kontakt ist.

14. Optoelektronische Vorrichtung, die eine Matrix von Fotodioden (1) nach einem der Ansprüche 9 bis 13 umfasst, wobei die Fotodioden (1) gemäß der Hauptebene koplanar sind.

## Claims

1. Method for fabricating at least one passivated planar photodiode (1), comprising the following steps:
i) producing a semiconductor segment (10) called the detection semiconductor segment, having first and second faces (10a, 10b) that are opposite each other and parallel to a main plane of the photodiode (1), and comprising:
∘ flush with the first face (10a), a region (13) called the intermediate region,
∘ flush with the second face (10b), a region (12) called the lower region, which is doped with a second conductivity type,
ii) depositing a passivation layer (20) that is made of a dielectric so that it covers the first face (10a), and forming, in the passivation layer (20), at least one through-aperture (22) that opens onto the first face (10a) and that at least partially encircles, in the main plane, a central portion of the detection semiconductor segment (10);
iii) producing a lateral segment (23) that is made of a semiconductor doped with the second conductivity type and that is intended to be electrically biased, this lateral segment being located in contact with the lower region (12);
**characterized in that** it furthermore comprises the following steps:
iv) producing at least one peripheral segment (21) that is made of a semiconductor containing dopants of the second conductivity type, and that rests on and in contact with the first face (10a) through the through-aperture (22);
v) carrying out an anneal, this ensuring a diffusion of the dopants from the peripheral segment (21) to the detection semiconductor segment (10), thus forming, in the detection semiconductor segment (10), a peripheral region (14) doped with the second conductivity type, which is flush with the first face (10a), encircles the central portion in the main plane and is intended to be located between, and at a nonzero distance from, a region (11) called the upper region and the lateral segment (23);
vi) producing, in the central portion of the detection semiconductor segment (10), the upper region (11), the latter being doped with a first conductivity type opposite the second type, being intended to be electrically biased, being flush with the first face (10a) and separated from the lower region (12) by the intermediate region (13), and being encircled in the main plane by the peripheral region (14).

2. Method according to Claim 1, the step of carrying out an anneal furthermore ensuring a diffusion of dopants of the second conductivity type from the lateral segment (23) to the detection semiconductor segment (10), thus forming, in the detection semiconductor segment (10), a lateral region (15) doped with the second conductivity type.

3. Method according to Claim 1 or 2, wherein the detection semiconductor segment (10) is made based on germanium and the lateral segment (23) is made based on silicon, the step of carrying out an anneal furthermore ensuring a diffusion of silicon from the lateral segment (23) to the detection semiconductor segment (10), thus forming, in the detection semiconductor segment (10), a lateral region (16) made based on silicon-germanium.

4. Method according to any one of Claims 1 to 3, comprising the following steps:
- producing a stack made of a semiconductor of interest, formed from a lower sublayer (42.1) doped with the second conductivity type and from an intermediate sublayer (42.2);
- producing a trench (24) that extends through the stack of the lower and intermediate sublayers (42.1, 42.2), thus defining the detection semiconductor segment (10) of the photodiode (1);
- simultaneously producing the lateral segment (23) and the peripheral segment (21) by depositing a semiconductor doped with the second conductivity type in the through-aperture (22) of the passivation layer (20) and in the trench (24).

5. Method according to any one of Claims 1 to 4, comprising a step of producing at least one reflective segment (31), the latter being located in contact with the peripheral segment (21) on a face opposite the detection semiconductor segment (10), and being made of a material that is reflective with respect to the incident light radiation intended to be detected by the photodiode (1).

6. Method according to Claim 5, wherein the reflective segment (31) is obtained by depositing a layer made of a metal on the peripheral segment (21), the latter being made based on silicon, and then carrying out a siliciding anneal, a reflective segment (31) made of the metal thus silicided thus being formed.

7. Method according to any one of Claims 1 to 6, wherein the step of producing the doped upper region (11) comprises the following substeps:
- producing a central segment (25) that is made of a semiconductor doped with the first conductivity type, and that is arranged in a through-aperture (26) called the central through-aperture of the passivation layer (20) located in the central portion, and in contact with the first face (10a);
- carrying out an anneal, this ensuring the diffusion of dopants of the first conductivity type from the central segment (25) to the detection semiconductor segment (10), thus forming the upper region (11).

8. Method according to Claim 7, wherein the step of producing the central segment (25) comprises the following substeps:
∘ depositing, in the central through-aperture (26), a semiconductor doped with the second conductivity type and identical to that of the peripheral segment (21);
∘ carrying out an ion implantation, in the central segment (25), of dopants of the first conductivity type.

9. Passivated planar photodiode (1), comprising:
∘ a semiconductor segment (10) called the detection semiconductor segment, having first and second faces (10a, 10b) that are opposite each other and parallel to a main plane of the photodiode (1), comprising:
• flush with the first face (10a), an upper region (11) doped with a first conductivity type,
• flush with the second face (10b), a lower region (12) doped with a second conductivity type opposite the first type,
• an intermediate region (13) located between the upper region (11) and lower region (12) and encircling the upper region (11) in the main plane,
∘ a passivation layer (20) that covers the first face (10a), comprising through-apertures (22) that are each filled with a peripheral segment (21) that is made of a semiconductor containing dopants of the second conductivity type and that rests on and in contact with the first face (10a) through the through-aperture (22);
∘ a lateral segment (23) that is made of a semiconductor doped with the second conductivity type and that is intended to be electrically biased, this lateral segment being located in contact with the lower region (12);
**characterized in that** the detection semiconductor segment (10) comprises:
∘ a peripheral region (14) doped with the second conductivity type, which is flush with the first face (10a), encircles the upper region (11) in the main plane and is located between, and at a nonzero distance from, the upper region (11) and the lateral segment (23).

10. Photodiode (1) according to Claim 9, comprising a central segment (25) that is made of a semiconductor doped with the first conductivity type and that is located in contact with the upper region (11) through a through-aperture (26) of the passivation layer (20).

11. Photodiode (1) according to Claim 10, wherein the peripheral segment (21) and the central segment (25) are coated with a reflective segment (31) made of a silicided metal.

12. Photodiode (1) according to any one of Claims 9 to 11, comprising a lateral segment (23) that is doped with the second conductivity type and that makes contact and encircles the detection semiconductor segment (10) in the main plane, and wherein the detection semiconductor segment (10) comprises a lateral region (15) that is doped with the second conductivity type and that makes contact with the lateral segment (23).

13. Photodiode (1) according to Claim 12, wherein the detection semiconductor segment (10) is made based on germanium and the lateral segment (23) is made based on silicon, the detection semiconductor segment (10) comprising a lateral region (16) made based on silicon-germanium and making contact with the lateral segment (23).

14. Optoelectronic device comprising a matrix-array of photodiodes (1) according to any one of Claims 9 to 13, wherein the photodiodes (1) are coplanar in the main plane.
